(19) **Europäisches Patentamt**

**European Patent Office**

**Office européen des brevets**

(11) **EP 1 633 043 A2**

(12) **EUROPÄISCHE PATENTANMELDUNG**

(43) Veröffentlichungstag:
   **08.03.2006 Patentblatt 2006/10**

(51) Int Cl.:
   ***H03K 5/156*** (2006.01)

(21) Anmeldenummer: **05090013.3**

(22) Anmeldetag: **28.01.2005**

(84) Benannte Vertragsstaaten:
   **AT BE BG CH CY CZ DE DK EE ES FI FR GB GR HU IE IS IT LI LT LU MC NL PL PT RO SE SI SK TR**
   Benannte Erstreckungsstaaten:
   **AL BA HR LV MK YU**

(30) Priorität: **29.01.2004 US 767971**

(71) Anmelder: **Infineon Technologies AG**
   **81669 München (DE)**

(72) Erfinder: **Schrödinger, Karl**
   **14089 Berlin (DE)**

(74) Vertreter: **Müller, Wolfram Hubertus et al**
   **Patentanwälte**
   **Maikowski & Ninnemann,**
   **Postfach 15 09 20**
   **10671 Berlin (DE)**

(54) **Schaltung und Verfahren zur Korrektur des Duty-Cycle-Wertes eines digitalen Datensignals**

(57)   Aufgabe der Erfindung ist es, eine Schaltung zur Korrektur des Duty-Cycle-Wertes eines digitalen Datensignals anzugeben. Die Schaltung soll störunempfindlich sein und mit sehr kleinen Signalpegeln zuverlässig arbeiten.

Diese Aufgabe wird erfindungsgemäß durch eine Schaltung (10) mit einer Duty-Cycle-Korrektureinrichtung (20) gelöst. Die Duty-Cycle-Korrektureinrichtung (20) korrigiert den Duty-Cycle-Wert eines Datensignals in Abhängigkeit eines an einem Steuereingang der Duty-Cycle-Korrektureinrichtung (20) anliegenden, digitalen Steuersignals und bildet an einem Signalausgang ein korrigiertes Datensignal. Die Schaltung weist einen mit dem Signalausgang und dem Steuereingang der Duty-Cycle-Korrektureinrichtung (20) in Verbindung stehenden digitalen Duty-Cycle-Detektor (30) auf, der den aktuellen Duty-Cycle-Wert des korrigierten Datensignals feststellt und das digitale Steuersignal für die Duty-Cycle-Korrektureinrichtung (20) derart erzeugt, dass die Abweichung des jeweils aktuellen Duty-Cycle-Werts von einem vorgegebenen Duty-Cycle-Wert minimal wird. Der Duty-Cycle-Detektor (30) enthält zur Bildung des Steuersignals einen digitalen Integrator (210).

FIG 1

**Beschreibung**

Beschreibung

Schaltung und Verfahren zur Korrektur des Duty-Cycle-Wertes eines digitalen Datensignals

Die Erfindung bezieht sich auf eine Schaltung und auf ein Verfahren zur Korrektur des Duty-Cycle-Wertes Dc eines digitalen Datensignals. Unter einem Duty-Cycle-Wert Dc wird nachfolgend das Verhältnis zwischen der Bitlänge $t_{Bit}$ ("High") eines "High"-Signals und der Bitlänge $t_{Bit}$ ("Low") eines "Low"-Signals verstanden. Es gilt also:

$$Dc = \frac{t_{Bit}(high)}{t_{Bit}(high) + t_{Bit}(low)}.$$

Stand der Technik:

Aus der Druckschrift "CMOS Digital Duty Cycle Correction Circuit For Multi-Phase Clock" (Y. C. Jang, S. J. Bae, H. J. Park; "Electronics Letters" 18. September 2003, vol. 39, Nr. 19, Seiten 1383 bis 1384) ist eine Schaltung zur Korrektur des Duty-Cycle-Wertes eines digitalen Datensignals bekannt. Die vorbekannte Schaltung weist eine Duty-Cycle-Korrektureinrichtung mit einem Flankenanstiegsdetektor ("Rising Edge Generator") und einen Flankenabfalldetektor ("Falling Edge Generator") auf. Dem Flankenabfalldetektor ist ein steuerbarer Phasenschieber vorgeordnet, der mittels eines Steuersignals ansteuerbar ist. Der steuerbare Phasenschieber wird von einem Duty-Cycle-Detektor angesteuert, der den Duty-Cycle-Wert des Datensignals am Signalausgang der Duty-Cycle-Korrektureinrichtung misst und ein derartiges Steuersignal zum steuerbaren Phasenschieber übermittelt, dass ein vorgegebener Duty-Cycle-Wert vom Datensignal am Signalausgang der Duty-Cycle-Korrektureinrichtung erreicht wird.

Der Duty-Cycle-Detektor der vorbekannten Schaltung weist zwei Stromintegratoren auf, die parallel geschaltet sind. Am Ausgang der beiden Stromintegratoren ist ein Komparator angeschlossen, dem ein digitaler Zähler nachgeschaltet ist. Bei den beiden Stromintegratoren handelt es sich um analoge Komponenten.

Aufgabe der Erfindung:

Ausgehend von dem vorbekannten Stand der Technik ist es eine Aufgabe der Erfindung, eine Schaltung bzw. ein Verfahren zur Korrektur des Duty-Cycle-Wertes eines digitalen Datensignals anzugeben. Die Schaltung und das Verfahren sollen störunempfindlich sein und mit sehr kleinen Signalpegeln zuverlässig arbeiten.

Zusammenfassung der Erfindung:

Die genannte Aufgabe wird erfindungsgemäß durch eine Schaltung gelöst, die eine Duty-Cycle-Korrektureinrichtung sowie einen Duty-Cycle-Detektor aufweist. Der Duty-Cycle-Detektor steuert mit einem Steuersignal die Duty-Cycle-Korrektureinrichtung derart an, dass das digitale Datensignal am Signalausgang der Duty-Cycle-Korrektureinrichtung einen vorgegebenen Duty-Cycle-Wert erreicht. Erfindungsgemäß weist der Duty-Cycle-Detektor zur Bildung des Steuersignals einen digitalen Integrator auf.

Ein wesentlicher Vorteil der erfindungsgemäßen Schaltung besteht darin, dass diese auf Grund des Einsatzes des digitalen Integrators besonders störunempfindlich ist. Auch sehr kleine Signalpegel können daher mit der erfindungsgemäßen Schaltung zuverlässig verarbeitet werden. Die besonders große Störunempfindlichkeit wird erfindungsgemäß dadurch erreicht, dass die im Zusammenhang mit der Korrektur von Duty-Cycle-Werten vorbekannten analogen Integratoren, wie sie beispielsweise in der Schaltung der eingangs genannten Druckschrift enthalten sind - durch einen digitalen Integrator ersetzt sind, der eine vollständige digitale Verarbeitung des Datensignals ermöglicht.

Ein weiterer wesentlicher Vorteil der erfindungsgemäßen Schaltung besteht darin, dass auf Grund des Einsatzes des digitalen Integrators die Pulslängen des digitalen Datensignals stark variieren können, ohne dass die Korrektur des Duty-Cycle-Wertes davon beeinträchtigt wird.

Ein dritter wesentlicher Vorteil der erfindungsgemäßen Schaltung besteht darin, dass vor der Korrektur des Duty-Cycle-Wertes vorab keine Mittelung der Pulslängen der Pulse des Datensignals vorgenommen werden muss; denn aufgrund der Verwendung des digitalen Integrators können auch Datensignale mit stark schwankenden Pulslängen verarbeitet werden.

Ein vierter wesentlicher Vorteil der erfindungsgemäßen Schaltung ist darin zu sehen, dass quasi beliebige Duty-Cycle-Werte eingestellt werden können. Eine Beschränkung auf einen Duty-Cycle-Wert von im Wesentlichen 50% ist nicht vorhanden.

Gemäß einer vorteilhaften Ausgestaltung der Erfindung ist vorgesehen, dass der Duty-Cycle-Detektor eine digitale Mittelungsschaltung aufweist, die die Zeitpunkte festlegt, zu denen das jeweilige Ausgangssignal des digitalen Integrators zur Bildung und Aktualisierung des Steuersignals herangezogen wird. Die Mittelungsschaltung bewirkt zum einen eine Mittelung der von dem mindestens einen digitalen Integrator verursachten Abtastfehler und zum anderen eine Mittelung der variablen Datenbitlängen des digitalen Datensignals, wodurch Mess- und Regelungsfehler bei der Korrektur des Duty-Cycle-Wertes deutlich vermindert werden.

Die digitale Mittelungsschaltung weist bevorzugt einen Signalflankenzähler auf, der die Signalflanken des korrigierten Datensignals zählt und das Erzeugen des digitalen Steuersignals in Abhängigkeit von seinem Zählerstand mit einem Triggersignal triggert. Der Signalflankenzähler legt somit fest, über welche Zeitspanne der digitale Integrator integrieren soll.

Besonders einfach und damit vorteilhaft erzeugt der Signalflankenzähler das Triggersignal jeweils dann, wenn er nach einem jeweils zuvor erfolgten Trigger-Vorgang eine vorgegebene Anzahl an neu aufgetretenen - also nach dem jeweils letzten Triggerzeitpunkt neu aufgetretenen - Signalflanken erneut gezählt hat.

Vorzugsweise weist die digitale Mittelungsschaltung einen Latchbaustein auf, der eingangsseitig mit einem Ausgang des digitalen Integrators verbunden ist und das Ausgangssignal des digitalen Integrators als Steuersignal der Duty-Cycle-Korrektureinrichtung durchschaltet, wenn an einem Steueranschluss des Latchbausteins ein Triggersignal des Signalflankenzählers anliegt. Der Latchbaustein arbeitet somit als eine Art Speicher, der ein Durchschalten des Ausgangssignals des digitalen Integrators jeweils dann vornimmt, wenn der Signalflankenzähler einen entsprechenden Zählerstand erreicht hat.

Der digitale Integrator weist vorzugsweise einen Taktgenerator und einen mit dem Taktgenerator verbundenen Aufwärts- und Abwärtszähler auf. Der Aufwärts- und Abwärtszähler zählt bei einem "High"-Pegel des korrigierten Datensignals hoch oder herunter und bei einem "Low"-Pegel des korrigierten Datensignals in entgegengesetzter Richtung. Dies bedeutet, dass bei einem Hochzählen im Falle eines "High"-Pegels ein Herunterzählen im Falle eines "Low"-Pegels erfolgt; stattdessen kann auch ein Hochzählen im Falle eines "Low"-Pegels und ein Herunterzählen im Falle eines "High"-Pegels erfolgen.

Bevorzugt ist der Aufwärts- und Abwärtszähler ausgangsseitig mit der bereits erwähnten digitalen Mittelungsschaltung verbunden, die die Zeitpunkte festlegt, zu denen das jeweilige Ausgangssignal des digitalen Integrators zur Bildung und Aktualisierung des Steuersignals herangezogen wird.

Vorzugsweise ist der Aufwärts- und Abwärtszähler ausgangsseitig mit einem Eingang des Latchbausteines der digitalen Mittelungsschaltung verbunden, wobei der Latchbaustein den jeweiligen Zählerstand des Aufwärts- und Abwärtszählers zur Bildung und Aktualisierung des Steuersignals übernimmt sowie an seinem Ausgang abgibt, wenn an einem Steueranschluss des Latchbausteins ein Triggersignal anliegt.

Im Übrigen wird es als vorteilhaft angesehen, wenn die Duty-Cycle-Korrektureinrichtung einen Flankenanstiegsdetektor und einen Flankenabfalldetektor aufweist, deren Ausgangssignale zur Bildung des korrigierten Datensignals herangezogen werden.

Vorzugsweise ist dem Flankenanstiegsdetektor und dem Flankenabfalldetektor jeweils ein Phasenschieber vorgeordnet, an dem eingangsseitig das Datensignal anliegt. Mindestens einer der beiden Phasenschieber, vorzugsweise der dem Flankenabfalldetektor vorgeordnete Phasenschieber, ist mittels eines Steueranschlusses ansteuerbar ausgestaltet, so dass eine externe Ansteuerung möglich ist.

Die Ansteuerung des ansteuerbaren Phasenschiebers erfolgt bevorzugt mit dem Latchbaustein des digitalen Integrators.

Darüber hinaus wird es als vorteilhaft angesehen, wenn am Ausgang des Flankenanstiegsdetektors und am Ausgang des Flankenabfalldetektors ein RS (Reset/Set)-Latch-Baustein angeschlossen ist, der mit den Ausgangssignalen des Flankenanstiegsdetektors und des Flankenabfalldetektors das korrigierte Datensignal bildet.

Zwischen dem Signalausgang der Duty-Cycle-Korrektureinrichtung und dem Ausgang des RS-Latch-Bausteins können elektrisch eine oder mehrere Buffer- oder Verstärker-Bausteine angeordnet sein, durch die das korrigierte Datensignal geleitet wird, bevor es am Signalausgang der Duty-Cycle-Korrektureinrichtung abgegeben wird.

Die Erfindung bezieht sich darüber hinaus auf ein Verfahren zur Duty-Cycle-Korrektur eines digitalen Datensignals.

Bezüglich eines solchen Verfahrens ist zur Lösung der eingangs angegebenen Aufgabe erfindungsgemäß vorgesehen, dass aus dem Datensignal zwei Hilfssignale mit einer vorgegebenen Phasenverschiebung zueinander gebildet werden. Mit den beiden Hilfssignalen wird ein bezüglich des Duty-Cycle-Wertes korrigiertes Datensignal gewonnen, indem die Abweichung des Duty-Cycle-Wertes des korrigierten Datensignals von einem Vorgabewert mittels eines Duty-Cycle-Detektors festgestellt und die Phasenverschiebung zwischen den Hilfssignalen derart eingestellt wird, dass die Abweichung des Duty-Cycle-Wertes vom Vorgabewert minimal wird. Mit dem Duty-Cycle-Detektor wird hierzu erfindungsgemäß eine digitale Integration durchgeführt.

Bezüglich der Vorteile des erfindungsgemäßen Verfahrens wird auf die obigen Ausführungen im Zusammenhang mit der erfindungsgemäßen Schaltung verwiesen, da die Vorteile der erfindungsgemäßen Schaltung den Vorteilen des erfindungsgemäßen Verfahrens im Wesentlichen entsprechen.

Bezüglich vorteilhafter Ausgestaltungen des erfindungsgemäßen Verfahrens wird auf die Unteransprüche zum nebengeordneten Verfahrensanspruch verwiesen.

Zur Erläuterung der Erfindung zeigen:

Figur 1　　ein Ausführungsbeispiel für eine erfindungsgemäße Schaltung zur Korrektur des Duty-Cycle-Wertes eines digitalen Datensignals, mit der Schaltung lässt sich auch das erfindungsgemäße Verfahren durchführen;

Figur 2    ein Ausführungsbeispiel für einen digitalen Duty-Cycle-Detektor für die Schaltung gemäß Figur 1;

Figur 3    die Funktionsweise der Schaltung gemäß Figur 1 und des digitalen Duty-Cycle-Detektors gemäß Figur 2 anhand von Signalverläufen;

Figur 4    eine Kennlinie zur Ansteuerung eines steuerbaren Phasenschiebers der Schaltung gemäß Figur 1 und

Figur 5    eine Tabelle, die beispielhaft digital kodierte Steuersignale zur Ansteuerung des Phasenschiebers gemäß der Figur 1 darstellt.

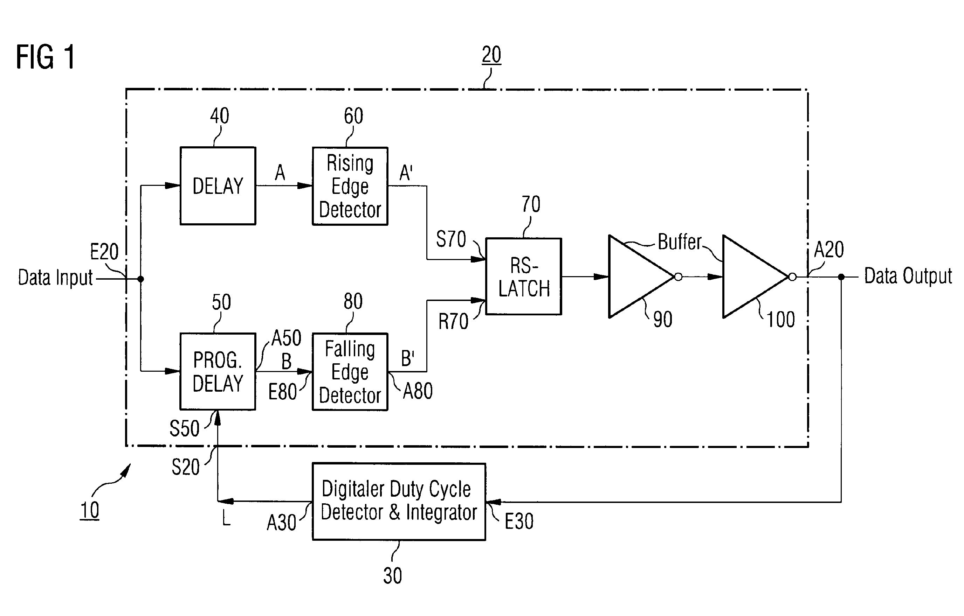

In der Figur 1 ist eine Schaltung zur Korrektur des Duty-Cycle-Wertes eines digitalen Datensignals "Data Input" dargestellt. Man erkennt eine Duty-Cycle-Korrektureinrichtung 20, an deren Signaleingang E20 das digitale Datensignal "Data Input" anliegt.

An einem Signalausgang A20 der Duty-Cycle-Korrektureinrichtung 20 wird von dieser ein korrigiertes Datensignal mit einem korrigierten Duty-Cycle-Wert erzeugt; das korrigierte Datensignal trägt in der Figur 1 das Bezugszeichen "Data Output".

Mit dem Signalausgang A20 der Duty-Cycle-Korrektureinrichtung 20 ist ein digitaler Duty-Cycle-Detektor 30 mit einem Eingang E30 verbunden. Ein Ausgang A30 des Duty-Cycle-Detektors 30 steht mit einem Steuereingang S20 der Duty-Cycle-Korrektureinrichtung 20 in Verbindung und steuert diese über ein Steuersignal L an.

Die Duty-Cycle-Korrektureinrichtung 20 weist eingangsseitig zwei Phasenschieber 40 und 50 auf, die eingangsseitig beide mit dem Datensignal "Data Input" beaufschlagt sind. Der eine Phasenschieber 40 bewirkt eine feste Phasenverschiebung von beispielsweise $t_{Bit}/2$.

Der weitere Phasenschieber 50 ist ein steuerbarer Phasenschieber, dessen Phasenverschiebung $\Delta\phi$ durch das Steuersignal L des digitalen Duty-Cycle-Detektors 30 am Steuereingang S50 eingestellt wird.

Dem einen Phasenschieber 40 ist ein Flankenanstiegsdetektor ("Rising Edge Detector") 60 nachgeschaltet, der wiederum ausgangsseitig mit einem Set-Eingang S70 eines RS-Latch-Bausteins 70 verbunden ist.

Ein Reset-Eingang R70 des RS-Latch-Bausteins 70 ist mit einem Ausgang A80 eines Flankenabfalldetektors 80 ("Falling Edge Detector") verbunden. Der Flankenabfalldetektor 80 steht mit einem Eingang E80 und mit einem Ausgang A50 des steuerbaren Phasenschiebers 50 in Verbindung.

Ein Ausgang A70 des RS-Latch-Bausteins 70 ist über zwei Inverter 90 und 100, die als Buffer-Elemente und Verstärker wirken, mit dem Signalausgang A20 verbunden.

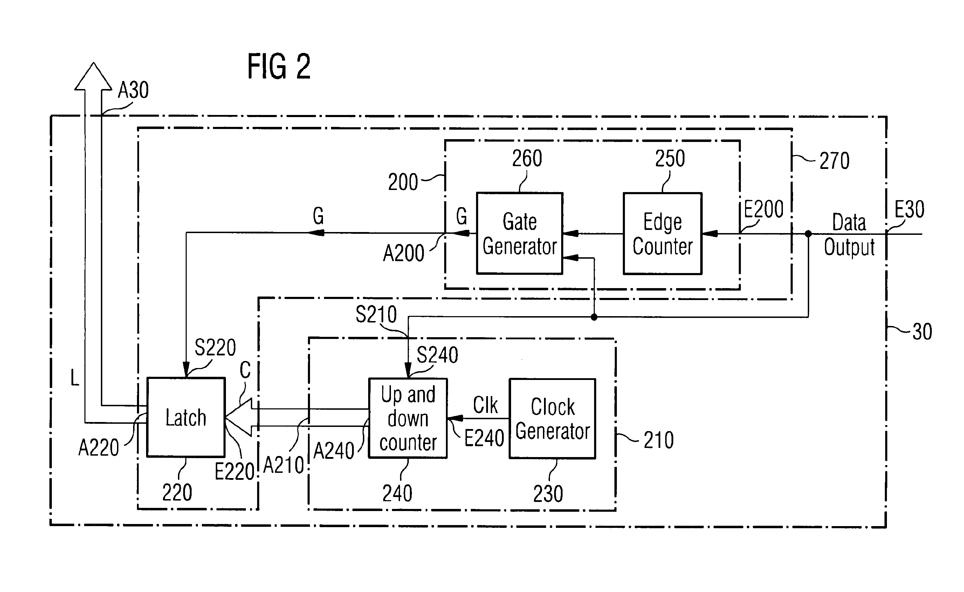

In der Figur 2 ist der Aufbau des digitalen Duty-Cycle-Detektors 30 gezeigt. Man erkennt den Eingang E30, an dem das korrigierte Datensignal "Data Output" an dem digitalen Duty-Cycle-Detektor 30 anliegt.

Mit dem Eingang E30 des Duty-Cycle-Detektors 30 steht ein Eingang E200 eines digitalen Signalflankenzählers 200 in Verbindung. Darüber hinaus ist der Eingang E30 des digitalen Duty-Cycle-Detektors 30 mit einem Steueranschluss S210 eines digitalen Integrators 210 verbunden.

Ein Ausgang A210 des digitalen Integrators 210 steht mit einem Eingang E220 eines Latch-Bausteins 220 in Verbindung, dessen Ausgang A220 den Ausgang A30 des Duty-Cycle-Detektors 30 gemäß Figur 1 bildet. Ein Steueranschluss S220 des Latch-Bausteins 220 ist mit einem Ausgang A200 des Signalflankenzählers 200 verbunden und wird von diesem über ein Triggersignal G getriggert.

Wie sich der Figur 2 entnehmen lässt, besteht der digitale Integrator 210 aus einem Taktgenerator 230, der ausgangsseitig mit einem Eingang E240 eines Aufwärts- und Abwärtszählers 240 verbunden ist. Der Aufwärts- und Abwärtszähler 240 weist einen Steueranschluss S240 auf, der den Steueranschluss S210 des digitalen Integrators 210 bildet und mit dem korrigierten Datensignal "Data Output" beaufschlagt ist. Der Ausgang A240 des Aufwärts- und Abwärtszählers 240 bildet den Ausgang A210 des digitalen Integrators.

In der Figur 2 ist darüber hinaus erkennbar, dass der Signalflankenzähler 200 einen Flankenzähler 250 ("Edge Counter") und einen nachgeschalteten Gate-Generator 260 aufweist. Am Ausgang des Gate-Generators 260 wird das Triggersignal G für den Latch-Baustein 220 gebildet.

Der Latchbaustein 220 sowie der durch den Flankenzähler 250 und den Gate-Generator 260 gebildete Signalflankenzähler 200 bilden eine digitale Mittelungsschaltung 270, die mit dem digitalen Integrator 210 zusammenwirkt.

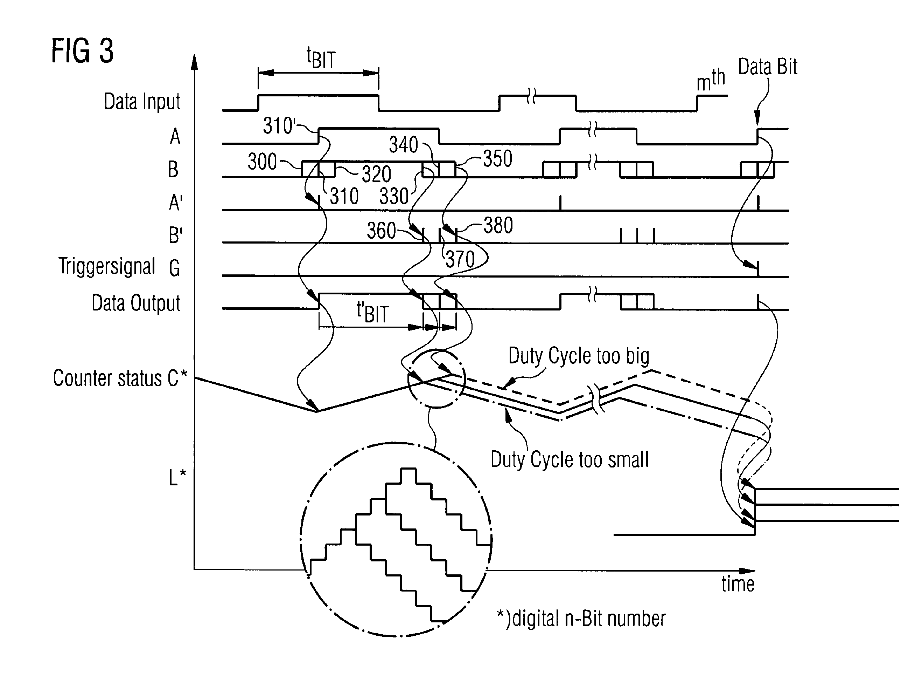

Die Funktionsweise der Schaltung zur Korrektur des Duty-Cycle-Wertes des digitalen Datensignals "Data-Input" wird nun nachfolgend anhand der in der Schaltung auftretenden Datensignale erläutert, die in der Figur 3 gezeigt sind.

Man erkennt in der Figur 3 den zeitlichen Verlauf des Datensignals "Data Input". Es ist zu sehen, dass der "High"-Pegel des Datensignals "Data-Input" eine Bitlänge "$t_{Bit}$" aufweist.

Das Datensignal "Data Input" wird am Signaleingang E20 in die Duty-Cycle-Korrektureinrichtung 20 eingespeist und gelangt zu den beiden Phasenschiebern 40 und 50, die eine Phasenverschiebung hervorrufen. Da es sich bei dem einen Phasenschieber 40 um einen Phasenschieber mit einer festen Phasenverschiebung handelt, entsteht am Ausgang des Phasenschiebers 40 das Signal A mit einer gegenüber dem Datensignal unveränderlichen Phasenverschiebung.

Am Ausgang des steuerbaren Phasenschiebers 50 entsteht das Signal B. Man erkennt, dass in der Figur 3 für das Signal B drei Signalanstiegsflanken 300, 310 und 320 eingezeichnet sind:

Die erste Anstiegsflanke 300 zeigt dabei den Signalflankenanstieg für den Fall, dass mit dem Steuersignal L eine Phasenverschiebung des Phasenschiebers 50 hervorgerufen wird, die kleiner als die Phasenverschiebung des Phasenschiebers 40 ist.

Die mittlere Anstiegsflanke 310 stellt die Anstiegsflanke für den Fall dar, dass mit dem Steuersignal L eine Phasenverschiebung in dem Phasenschieber 50 eingestellt wird, die der Phasenverschiebung des Phasenschiebers 40 entspricht. In einem solchen Fall treten also die Signalanstiegsflanke 310 des Signals B sowie die Anstiegsflanke 310' des Signals A zeitgleich auf.

Das Bezugszeichen 320 symbolisiert die Signalanstiegsflanke des Signals B für den Fall, dass mit dem Steuersignal L eine Phasenverschiebung des Phasenschiebers 50 hervorgerufen wird, die größer als die Phasenverschiebung des Phasenschiebers 40 ist.

In entsprechender Weise symbolisieren die Bezugszeichen 330, 340 und 350 die zugehörige Signalabfallflanke des Signals B jeweils für die kleinere, die mittlere und die größere Phasenverschiebung des Phasenschiebers 50.

Das von dem einen Phasenschieber 40 erzeugte Ausgangssignal A gelangt zu dem Flankenanstiegsdetektor 60, der daraus ein Signal A' bildet. Bei dem Signal A' handelt es sich um einen Impuls, der zu dem Zeitpunkt auftritt, zu dem das Signal A seinen Signalanstieg aufweist.

Das von dem weiteren Phasenschieber 50 erzeugte Ausgangssignal B gelangt zu dem Flankenabfalldetektor 80, der damit ein Signal B' bildet. Das Signal B' ist ebenfalls ein pulsförmiges Signal und tritt stets dann auf, wenn das Signal B am Eingang E80 des Flankenabfalldetektors 80 eine fallende Signalflanke aufweist. In der Figur 3 sind diesbezüglich drei Signalimpulse 360, 370 und 380 dargestellt: Der Impuls 360 bezieht sich auf die Signalabfallflanke 330 des Signals B; der mittlere Impuls 370 bezieht sich auf die Abfallflanke 340 des Signals B und der Impuls 380 auf die Abfallflanke 350 des Signals B. Diese Zuordnung ist in der Figur 3 durch geschwungene bzw. sinusförmige Pfeile dargestellt.

Die beiden Signale A' und B' des Flankenanstiegsdetektors 60 und des Flankenabfalldetektors 80 gelangen zu dem RS-Latch-Baustein 70, der damit das korrigierte Datensignal "Data Output" bildet. Konkret wird am Ausgang A70 des RS-Latch-Bausteins 70 ein "High"-Signal erzeugt, wenn am Set-Eingang S70 des RS-Latch-Bausteins 70 ein Signalimpuls anliegt. Das korrigierte Datensignal "Data Output" wird auf einen "Low"-Pegel zurückgeschaltet, sobald am Reset-Eingang R70 das Signal B' seinen Impuls 360, 370 bzw. 380 aufweist.

Zusammengefasst lässt sich damit feststellen, dass die Bitlänge $t'_{Bit}$ des "High"-Pegels des korrigierten Datensignals "Data Output" davon abhängt, welche Phasenverschiebung am Steueranschluss S50 des steuerbaren Phasenschiebers 50 eingestellt wird.

Die Ansteuerung des weiteren Phasenschiebers 50 am Steueranschluss S50 erfolgt mittels des Duty-Cycle-Detektors 30 in folgender Weise: Am Eingang E30 des Duty-Cycle-Detektors 30 wird das korrigierte Datensignal "Data Output" in die digitale Mittelungsschaltung 270 sowie an einem Steueranschluss S210 in den digitalen Integrator 210 eingespeist. Der in dem digitalen Integrator 210 vorhandene Taktgenerator 230 erzeugt ein Taktsignal Clk, dessen Taktfrequenz größer als die Datenrate des Datensignals "Data Input" bzw. des korrigierten Datensignals "Data Output" ist. Dadurch wird - wie nachfolgend deutlich werden wird - eine Überabtastung des Datensignals "Data Output" gewährleistet.

Vorteilhaft beträgt die Taktfrequenz $f_{Clk}$ des Taktsignals Clk ein Mehrfaches der Datenrate des Datensignals "Data Ouput". Es gilt also:

$$f_{Clk} = N * 1/t_{Bit}.$$

wobei $t_{Bit}$ die Bitlänge des Datensignals Data Input bzw. Data Output angibt. N ist eine beliebige reelle Zahl größer als Eins. N kann beispielsweise eine ganze Zahl sein.

Der dem Taktgenerator 230 nachgeschaltete Aufwärts- und Abwärtszähler 240 zählt nun die Takte des Taktsignals Clk des Taktgenerators 230. Dabei wird die Zählrichtung des Aufwärts- und Abwärtszählers 240 durch das an dem Steueranschluss S210 des digitalen Duty-Cycle-Detektors 210 und damit an dem Steueranschluss S240 des Aufwärts- und Abwärtszählers 240 anliegende korrigierte Datensignal "Data Output" bestimmt. Weist das korrigierte Datensignal "Data Output" einen "High"-Pegel auf, so wird mit dem Aufwärts- und Abwärtszähler beispielsweise hochgezählt. Weist das korrigierte Datensignal "Data Output" hingegen einen "Low"-Pegel auf, so wird entsprechend heruntergezählt.

Alternativ kann die Zählrichtung des Aufwärts- und Abwärtszählers 240 auch genau umgekehrt sein: Dies bedeutet, dass bei einem "High"-Pegel des korrigierten Datensignals "Data Output" heruntergezählt und bei einem "Low"-Pegel des korrigierten Datensignals "Data Output" hochgezählt wird.

Der Aufwärts- und Abwärtszähler 240 führt auf Grund der in Abhängigkeit des Pegels des korrigierten Datensignals "Data Output" wechselnden Zählrichtung eine Art Integration durch, deren Integrationswert den Duty-Cycle-Wert des korrigierten Datensignals "Data Output" angibt: Ist nämlich die Bitlänge $t_{Bit}$("high") eines "High"-Pegels genau so lang wie die Bitlänge $t_{Bit}$("low") eines "Low"-Pegels, so wird am Ausgang A240 des Aufwärts- und Abwärtszählers 240 als Zählerstand eine Null erscheinen, da genau so lang "hochgezählt" wie "heruntergezählt" wird. Bei einem Duty-Cycle-Wert von 50% entsteht am Ausgang des Aufwärts- und Abwärtszählers 240 also eine Null.

Verschiebt sich der Duty-Cycle-Wert des korrigierten Datensignals Data Output zu höheren oder zu tieferen Werten, so wird am Ausgang A240 des Aufwärts- und Abwärtszählers 240 eine von Null verschiedene Zahl auftreten.

Wird - wovon nachfolgend beispielhaft ausgegangen wird - im Falle eines "High"-Pegels des korrigierten Datensignals "Data Output" hoch- und bei einem "Low"-Pegel des korrigierten Datensignals "Data Output" heruntergezählt, so wird bei einem Duty-Cycle-Wert Dc unter 50% der Zähler "länger" nach unten als nach oben zählen, so dass sich am Ausgang A240 des Aufwärts- und Abwärtszählers 240 ein negativer Zählerstand bilden wird.

Wie bereits eingangs erwähnt, berechnet sich der Duty-Cycle-Wert Dc gemäß:

$$\mathrm{Dc} \;=\; \frac{t_{Bit}(high)}{t_{Bit}(high) + t_{Bit}(low)} \;.$$

Überschreitet der Duty-Cycle-Wert hingegen einen Wert von 50%, so wird "länger" hoch- als heruntergezählt, so dass sich am Ausgang A240 des Aufwärts- und Abwärtszählers 240 ein positiver Zählerstand bilden wird.

Zusammengefasst lässt sich damit feststellen, dass der Zählerstand am Ausgang A240 des Aufwärts- und Abwärtszählers 240 den Duty-Cycle-Wert des Datensignals "Data Output" wiedergibt.

Der Zählerstand C am Ausgang A240 des Aufwärts- und Abwärtszählers 240 ist in der Figur 3 als "Counter Staus C" bezeichnet. Man erkennt, dass der Zählerstand schwankt und sich erhöht, wenn das Datensignal "Data Output" einen "High"-Pegel aufweist und sich reduziert, wenn das korrigierte Datensignal "Data Output" einen "Low"-Pegel aufweist.

In der Figur 3 ist mittels einer durchgezogenen Linie dabei der Fall dargestellt, dass der Duty-Cycle-Wert exakt 50% beträgt. Die gestrichelte, also obere Linie gibt den Verlauf des Zählerstandes C für den Fall an, dass der Duty-Cycle-Wert größer als 50% bzw. zu groß ist. Die strichpunktierte, also untere Linie gibt den Zählerstand C für den Fall an, dass der Duty-Cycle-Wert kleiner als 50% ist.

Der jeweilige Zählerstand C wird nun nicht unmittelbar an den Steueranschluss S50 des Phasenschiebers 50 durchgeschaltet, sondern stattdessen in die digitale Mittelungsschaltung 270 eingespeist. Konkret gelangt der Zählerstand C zu dem Latch-Baustein 220, der den Zählerstand C als Steuersignal L stets zu denjenigen Zeitpunkten an die Duty-Cycle-Korrektureinrichtung 20 weiterleitet, zu denen an dem Steueranschluss S220 des Latch-Bausteins 220 ein Triggersignal G anliegt. Das Triggersignal G wird von dem Gate-Generator 260 des Signalflankenzählers 200 stets dann erzeugt, wenn der Flankenzähler 250 des Signalflankenzählers 200 eine vorgegebene Anzahl an Flankenwechseln bzw. Bitwechseln festgestellt hat.

Dies ist in der Figur 3 ersichtlich, da in der Figur 3 auch das Triggersignal G eingezeichnet ist. Man erkennt, dass bei Auftreten des Triggersignals G der jeweilige Zählerstand C des Aufwärts- und Abwärtszählers 240 an den Ausgang A220 des Latch-Bausteins 220 übernommen wird und sich somit das Steuersignal L bildet, das den Zählerstand C wiedergibt.

Das Steuersignal L ist in der Figur 3 ebenfalls dargestellt. Man erkennt, dass die Höhe des Steuersignals L vom jeweiligen Zählerstand C des Auf- und Abwärtszählers 240 abhängt.

Zusammengefasst lässt sich damit feststellen, dass der Taktgenerator 230 und der Aufwärts- und Abwärtszähler 240 einen digitalen Integrator bilden, der eine digitale Integration des korrigierten Datensignals "Data Output" durchführt. Dadurch, dass die Taktfrequenz des Taktsignals Clk ein Vielfaches der Datenrate des Datensignals "Data Output" beträgt, wird eine Überabtastung erreicht, durch die der Abtastfehler bei der digitalen Integration reduziert wird. Konkret beträgt der zeitliche Abtastfehler $T_{ABT}$:

$$T_{ABT} \;=\; \frac{1}{f_{Clk}} \;,$$

so dass bei zunehmender Taktfrequenz der Abtastfehler kleiner wird.

Durch die digitale Mittelungsschaltung 270 wird im Übrigen im Rahmen der digitalen Integration des digitalen Integrators 210 eine Vielzahl an Datenbits berücksichtigt. Je nach der Kodierung des Datensignals "Data Input" kann es dazu kommen, dass eine Vielzahl an "High"- oder "Low"-Pegeln hintereinander übertragen wird. Um zu vermeiden, dass eine solche Aneinanderreihung identischer Signalpegel zu einem falschen Integrationsergebnis im digitalen Integrator 210 führt, ist die digitale Mittelungsschaltung 270 vorgesehen, die eine zeitliche Mittelung über einen längeren Zeitraum erzwingt. Konkret wird nämlich die Integration im digitalen Integrator 210 stets solange durchgeführt, wie dies von dem Signalflankenzähler 200 vorgegeben wird. Der Signalflankenzähler 200 stellt somit sicher, dass stets eine vorgegebene Anzahl an unterschiedlichen Signalpegeln bei der digitalen Integration berücksichtigt wird. Es wird also eine "Mindestintegrationszeit" durch den Signalflankenzähler 200 bzw. durch die digitale Mittelungsschaltung 270 erzwungen.

Um nun zu erreichen, dass mit dem weiteren Phasenschieber 50 ein geeigneter Phasenverschiebungswert eingestellt wird, muss der Duty-Cycle-Detektor 30 eine geeignete Rückkoppelschleife bilden. Dies erfordert, dass der Duty-Cycle-Detektor 30 eine "negative" Kennlinie bzw. eine negative Rückkopplung der Regelschleife aufweist.

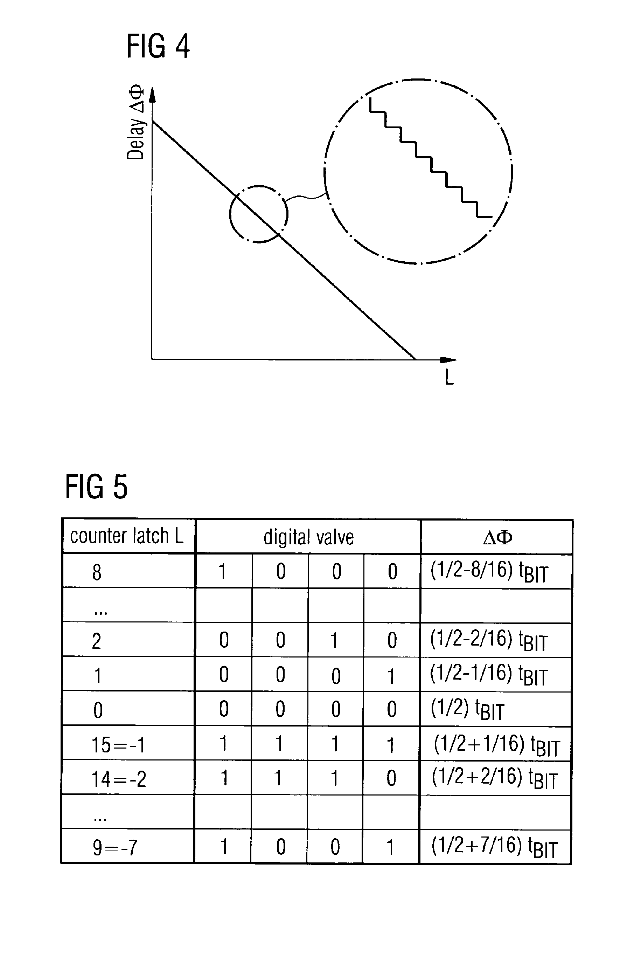

Eine solche negative Kennlinie bzw. negative Rückkopplung ist in der Figur 4 gezeigt. Man erkennt in der Figur 4 die durch den weiteren Phasenschieber 50 hervorgerufene Phasenverschiebung $\Delta\phi$ ("Delay") in Abhängigkeit vom Steuersignal L.

Das Steuersignal L ist dabei durch eine digitale Zahl bestimmt, die durch eine vorgegebene Anzahl an Bits repräsentiert wird. Handelt es sich bei dem Auf- und Abwärtszähler 240 um einen Vier-Bit-Zähler, so kann eine Kodierung des Steuersignals L beispielsweise so aussehen, wie dies in der Tabelle gemäß Figur 5 dargestellt ist. Man erkennt in der Figur 5, dass bei einem Zählerstand von Null ("0000") der weitere Phasenschieber 50 derart angesteuert wird, dass er eine Phasenverschiebung von

$$\Delta\Phi = 1/2 * t_{Bit}$$

hervorruft. Bei Zählerständen größer als Null wird die von dem weiteren Phasenschieber 50 hervorgerufene Phasenverschiebung $\Delta\Phi$ reduziert. Beispielsweise tritt bei einem Zählerstand von 2 (digitaler Wert "0010") eine Phasenverschiebung von nur

$$\Delta\Phi = (1/2 - 2/16) * t_{Bit}$$

auf.

Negative Zählerstände, beispielsweise ein Zählerstand von -1, werden durch einen Überlauf des Zählers berücksichtigt. Ein Zählerstand von -1 entspricht damit einem Zählerstand von 15 im Falle eines Vier-Bit-Zählers, so dass sich eine digitale Zahl "1111" als Zählerstand bildet. Ein solcher Zählerstand teilt dem weiteren Phasenschieber 50 mit, dass eine Phasenverschiebung

$$\Delta\Phi = (1/2 + 1/16) * t_{Bit}$$

eingestellt werden soll.

Die übrigen negativen Zählerstände werden durch Rückwärtszählen erreicht, wie dies in der Tabelle gemäß Figur 5 erkennbar ist. Beispielsweise wird bei einem Zählerstand von -2 ("1110") dem weiteren Phasenschieber 50 mitgeteilt, dass eine Phasenverschiebung von

$$\Delta\Phi = (1/2 + 2/16) * t_{Bit}$$

erzeugt werden soll.

Um nun zu erreichen, dass es zu keinem Phasensprung bei einem Wechsel des Digitalwertes von "1000" zu "1001" bzw. von "1001" zu "1000" kommen kann, wird der jeweilige Phasenwert $\Delta\Phi$ gespeichert und festgehalten, wenn bei einem Zählerstand von "8" nach oben und bei einem Zählerstand von "9" nach unten gezählt wird. Wird also der mittels des weiteren Phasenschiebers 50 einstellbare Phasenbereich verlassen, so sorgt der Latch-Baustein 220 dafür, dass der maximale Phasenverschiebungswert

$$\Delta\Phi = (1/2 + 7/16) * t_{Bit}$$

bzw. der minimale Phasenverschiebungswert

$$\Delta\Phi = (1/2 - 8/16) * t_{Bit}$$

beibehalten wird.

Der Latch-Baustein 220 kann für diese Funktionalität mit einem internen oder externen Prozessor ausgestattet sein.

Um eine störungsfreie Funktionsweise der Schaltung gemäß den Figuren 1 und 2 zu gewährleisten, ist die Zählerlänge des Auf- und Abwärtszählers 240, die Bitlänge des Latch-Bausteins 220 sowie die Auflösung des Phasenschiebers 50 bezüglich der Bitzahl aneinander angepasst; dies bedeutet, dass diese Komponenten vorzugsweise mit der gleichen Bitlänge arbeiten.

Abschließend sei erwähnt, dass über die Zählerlängen des Signalflankenzählers 200 und des Auf- und Abwärtszählers 240 sowie mittels der Taktfrequenz $f_{Clk}$ des Taktsignals Clk des Taktgenerators 230 die Regelzeiten der Duty-Cycle-Korrektureinrichtung eingestellt werden können.

Bezugszeichenliste

| 10 | Schaltung zur Korrektur des Duty-Cycle-Wertes eines Datensignals |
| --- | --- |
| 20 | Duty-Cycle-Korrektureinrichtung |
| 30 | Duty-Cycle-Detektor |
| 40 | Phasenschieber |
| 50 | Steuerbarer Phasenschieber |
| 60 | Flankenanstiegsdetektor |
| 70 | RS-Latch-Baustein |
| 80 | Flankenabfalldetektor |
| 90/100 | Bufferelemente |
| 200 | Signalflankenzähler |
| 210 | Digitaler Integrator |
| 220 | Latch-Baustein |
| 230 | Taktgenerator |
| 240 | Auf- und Abwärtszähler |
| 250 | Flankenzähler |
| 260 | Gategenerator |
| 270 | Digitale Mittelungsschaltung |
| A | Ausgangssignal des Phasenschiebers 40 |

| | |
|---|---|
| B | Ausgangssignal des steuerbaren Phasenschiebers 50 |
| A' | Ausgangssignal des Flankenanstiegsdetektors 60 |
| B' | Ausgangssignal des Flankenabfalldetektors |
| Data Output | Korrigiertes Datensignal |
| G | Triggersignal G des Signalflankenzählers 200 |
| Clk | Taktsignal des Taktgenerators 230 |
| Counter Status C | Zählerstand des Aufwärts- und Abwärtszählers 240 |
| L | Digitales Steuersignal am Ausgang des Latch-Bausteins 220 |

**Patentansprüche**

1. Schaltung (10) zur Korrektur des Duty-Cycle-Wertes eines digitalen Datensignals

   - mit einer mit dem Datensignal an einem Signaleingang beaufschlagten Duty-Cycle-Korrektureinrichtung (20), die den Duty-Cycle-Wert in Abhängigkeit eines an einem Steuereingang der Duty-Cycle-Korrektureinrichtung (20) anliegenden, digitalen Steuersignals korrigiert und an einem Signalausgang ein korrigiertes Datensignal bildet, und
   - mit einem mit dem Signalausgang und dem Steuereingang der Duty-Cycle-Korrektureinrichtung (20) in Verbindung stehenden digitalen Duty-Cycle-Detektor (30), der den aktuellen Duty-Cycle-Wert des korrigierten Datensignals feststellt und das digitale Steuersignal für die Duty-Cycle-Korrektureinrichtung (20) derart erzeugt, dass die Abweichung des aktuellen Duty-Cycle-Werts von einem vorgegebenen Duty-Cycle-Wert minimal wird,
   - wobei der Duty-Cycle-Detektor (30) zur Bildung des Steuersignals einen digitalen Integrator (210) aufweist.

2. Schaltung nach Anspruch 1, **dadurch gekennzeichnet, dass** der Duty-Cycle-Detektor (30) eine digitale Mittelungsschaltung (270) aufweist, die die Zeitpunkte festlegt, zu denen das jeweilige Ausgangssignal des digitalen Integrators zur Bildung und Aktualisierung des Steuersignals herangezogen wird.

3. Schaltung nach Anspruch 2, **dadurch gekennzeichnet, dass** die digitale Mittelungsschaltung (270) einen Signalflankenzähler (200) aufweist, der die Signalflanken des korrigierten Datensignals zählt und das Erzeugen des digitalen Steuersignals in Abhängigkeit von seinem Zählerstand mit einem Triggersignal triggert.

4. Schaltung nach Anspruch 3, **dadurch gekennzeichnet, dass** der Signalflankenzähler (200) derart ausgestaltet ist, dass er das Erzeugen des digitalen Steuersignals jeweils dann triggert, wenn er nach einem jeweils zuvor erfolgten Triggern eine vorgegebene Anzahl an aufgetretenen Signalflanken erneut gezählt hat.

5. Schaltung nach Anspruch 4, **dadurch gekennzeichnet, dass** die digitale Mittelungsschaltung (270) einen Latch-Baustein (220) aufweist, der eingangsseitig mit einem Ausgang des digitalen Integrators verbunden ist und das Ausgangssignal des digitalen Integrators als Steuersignal der Duty-Cycle-Korrektureinrichtung durchschaltet, wenn an einem Steueranschluss des Latch-Bausteins ein Triggersignal des Signalflankenzählers anliegt.

6. Schaltung nach Anspruch 1, **dadurch gekennzeichnet, dass** der digitale Integrator (210) einen Taktgenerator (230) und einen mit dem Taktgenerator (230) verbundenen Aufwärts- und Abwärtszähler (240) aufweist, der bei einem "High"-Pegel des korrigierten Datensignals hoch- oder herunterzählt und bei einem "Low"-Pegel des korrigierten Datensignals in entgegensetzter Richtung zählt, also herunter- bzw. hochzählt.

7. Schaltung nach Anspruch 6, **dadurch gekennzeichnet, dass** der Aufwärts- und Abwärtszähler (240) ausgangsseitig mit einer digitalen Mittelungsschaltung (270) verbunden ist, die die Zeitpunkte festlegt, zu denen das jeweilige Ausgangssignal des digitalen Integrators zur Bildung und Aktualisierung des Steuersignals herangezogen wird.

8. Schaltung nach Anspruch 7, **dadurch gekennzeichnet, dass** der Aufwärts- und Abwärtszähler (240) ausgangsseitig mit einem Eingang eines Latch-Bausteines (220) der digitalen Mittelungsschaltung (270) verbunden ist,

   - wobei der Latch-Baustein den jeweiligen Zählerstand des Aufwärts- und Abwärtszählers zur Bildung und Aktualisierung des Steuersignals übernimmt sowie an seinem Ausgang abgibt, wenn an einem Steueranschluss des Latch-Bausteins ein Triggersignal anliegt.

9. Schaltung nach Anspruch 8, **dadurch gekennzeichnet, dass**

   - der Latch-Baustein (220) mit seinem Steueranschluss mit dem Ausgang eines Signalflankenzählers (200) der digitalen Mittelungsschaltung in Verbindung steht,
   - wobei der Signalflankenzähler (200) die Signalflanken des korrigierten Datensignals zählt und das Erzeugen des digitalen Steuersignals in Abhängigkeit von seinem Zählerstand mit einem Triggersignal triggert.

10. Schaltung nach Anspruch 9, **dadurch gekennzeichnet, dass** der Latch-Baustein (220) den jeweiligen Zählerstand des Aufwärts- und Abwärtszählers (240) übernimmt, wenn an seinem Steueranschluss das Triggersignal des Signalflankenzählers anliegt.

11. Schaltung nach Anspruch 10, **dadurch gekennzeichnet, dass** der Ausgang des Latch-Bausteins (220) einen Ausgang des Duty-Cycle-Detektors (30) bildet und an den digitalen Steuereingang der Duty-Cycle-Korrektureinrichtung (20) angeschlossen ist.

12. Schaltung nach Anspruch 9, **dadurch gekennzeichnet, dass** zwischen den Steueranschluss des Latch-Bausteins (220) und den Ausgang des Signalflankenzählers (200) ein Gate-Generator zwischengeschaltet ist, der bei einem vorgegebenen Zählerstand des Signalflankenzählers einen definierten Impuls für den Latch-Baustein erzeugt.

13. Schaltung nach Anspruch 1, **dadurch gekennzeichnet, dass** die Duty-Cycle-Korrektureinrichtung (20) einen Flankenanstiegsdetektor (60) und einen Flankenabfalldetektor (80) aufweist, deren Ausgangssignale zur Bildung des korrigierten Datensignals herangezogen werden.

14. Schaltung nach Anspruch 13, **dadurch gekennzeichnet, dass** dem Flankenanstiegsdetektor (60) und dem Flankenabfalldetektor (80) jeweils ein Phasenschieber (40, 50) vorgeordnet ist, an dem eingangsseitig das Datensignal anliegt.

15. Schaltung nach Anspruch 14, **dadurch gekennzeichnet, dass** einer der beiden Phasenschieber (50) mittels eines Steueranschlusses ansteuerbar ist und der Steueranschluss des Phasenschiebers (50) den digitalen Steuereingang der Duty-Cycle-Korrektureinrichtung (20) bildet.

16. Schaltung nach Anspruch 15, **dadurch gekennzeichnet, dass** der ansteuerbare Phasenschieber (50) dem Flankenabfalldetektor (80) vorgeschaltet ist.

17. Schaltung nach Anspruch 16, **dadurch gekennzeichnet, dass** am Ausgang des Flankenanstiegsdetektors (60) und am Ausgang des Flankenabfalldetektors (80) ein RS-Latch-Baustein (70) angeschlossen ist, der mit deren Ausgangssignalen das korrigierte Datensignal bildet.

18. Schaltung nach Anspruch 17, **dadurch gekenn-**

**zeichnet, dass** am Ausgang des RS-Latch-Bausteins (70) ein oder mehrere Buffer-Bausteine (90, 100) angeschlossen sind, durch die das korrigierte Datensignal geleitet wird, bevor es am Ausgang der Duty-Cycle-Korrektureinrichtung abgegeben wird.

19. Verfahren zur Duty-Cycle-Korrektur eines digitalen Datensignals,

- bei dem aus dem Datensignal zwei Hilfssignale mit einer vorgegebenen Phasenverschiebung zueinander gebildet werden und
- mit den beiden Hilfssignalen ein bezüglich des Duty-Cycle-Wertes korrigiertes Datensignal gewonnen wird,
- wobei die Abweichung des Duty-Cycle-Wertes des korrigierten Datensignals von einem Vorgabewert mittels eines Duty-Cycle-Detektors festgestellt und die Phasenverschiebung zwischen den Hilfssignalen derart eingestellt wird, dass die Abweichung des Duty-Cycle-Wertes vom Vorgabewert minimal wird, und
- wobei mit dem Duty-Cycle-Detektor eine digitale Integration durchgeführt wird.

20. Verfahren nach Anspruch 19, **dadurch gekennzeichnet, dass**

- mit einem Signalflankenzähler die Signalflanken des korrigierten Datensignals gezählt werden und
- die Phasenverschiebung zwischen den Hilfssignalen neu eingestellt wird,
- wenn nach einer jeweils zuvor erfolgten Einstellung der Phasenverschiebung mit dem Signalflankenzähler eine vorgegebene Anzahl an Signalflanken erneut gezählt worden ist.

21. Verfahren nach Anspruch 20, **dadurch gekennzeichnet, dass**

- die Taktsignale eines Taktgenerators mit einem Aufwärts und Abwärtszähler gezählt werden, wobei der Zählerstand des Aufwärts- und Abwärtszählers
- hoch- oder heruntergezählt wird, wenn das korrigierte Datensignal einen "High"-Pegel aufweist, und
- in entgegengesetzter Richtung herunter bzw. hoch gezählt wird, wenn das korrigierte Datensignal einen "Low"-Pegel aufweist, und
- der jeweilige Zählerstand des Aufwärts- und Abwärtszählers als Steuersignal zur Einstellung der Phasenverschiebung zwischen den zwei Hilfssignalen herangezogen wird.

22. Verfahren nach Anspruch 21, **dadurch gekennzeichnet, dass**

- die Phasenverschiebung zwischen den Hilfssignalen unter Heranziehung des jeweiligen Zählerstands des Aufwärts- und Abwärtszählers neu eingestellt wird,
- sobald nach einer jeweils zuvor erfolgten Einstellung der Phasenverschiebung mit dem Signalflankenzähler eine vorgegebene Anzahl an Signalflanken erneut gezählt worden ist.

FIG 1

EP 1 633 043 A2

FIG 2

EP 1 633 043 A2

FIG 3

| | $^{t}BIT$ | | | | | | $m^{th}$ | Data Bit |

Data Input

A    310'

B    300    340    350
         320
A'    310    330

B'    360    380
            370

Triggersignal  G

Data Output    $t'BIT$

Counter status C*

Duty Cycle too big

Duty Cycle too small

L*

time

*)digital n-Bit number

EP 1 633 043 A2

## FIG 4

## FIG 5

| counter latch L | digital valve | | | | $\Delta\Phi$ |
|---|---|---|---|---|---|
| 8 | 1 | 0 | 0 | 0 | $(1/2-8/16)\ t_{BIT}$ |
| ... | | | | | |
| 2 | 0 | 0 | 1 | 0 | $(1/2-2/16)\ t_{BIT}$ |
| 1 | 0 | 0 | 0 | 1 | $(1/2-1/16)\ t_{BIT}$ |
| 0 | 0 | 0 | 0 | 0 | $(1/2)\ t_{BIT}$ |
| 15=-1 | 1 | 1 | 1 | 1 | $(1/2+1/16)\ t_{BIT}$ |
| 14=-2 | 1 | 1 | 1 | 0 | $(1/2+2/16)\ t_{BIT}$ |
| ... | | | | | |
| 9=-7 | 1 | 0 | 0 | 1 | $(1/2+7/16)\ t_{BIT}$ |